# EUROPÄISCHE PATENTSCHRIFT

(11) **EP 1 489 709 B1**
(45) Veröffentlichungstag und Bekanntmachung des Hinweises auf die Patenterteilung: **08.09.2010**
(21) Anmeldenummer: 04013222.7
(22) Anmeldetag: 04.06.2004
(51) Int. Cl.: H02B 1/052, H05K 7/14

(54) **In ein Installationsgehäuse einsetzbare, in einem Gehäuse untergebrachte Schalt- oder Steuereinrichtung**
Switching or controlling device accommodated in and applicable into an installation housing
Dispositif de commande ou de commutation logé et installé dans un coffret pour une installation électrique

(30) Priorität: 18.06.2003 DE 10327378
(43) Veröffentlichungstag der Anmeldung: 22.12.2004
(73) Patentinhaber: ABB AG, 68309 Mannheim (DE)
(72) Erfinder: Krambs, Markus, 69190 Walldorf (DE); Ohnesorg, Andreas, 76684 Östringen-Odenheim (DE)
(74) Vertreter: Miller, Toivo

(56) Entgegenhaltungen:
- EP-A- 0 798 834
- EP-A- 1 100 152
- DE-C1- 19 743 949
- DE-U1- 9 310 630

## Beschreibung

Die Erfindung betrifft eine Schalt- oder Steuereinrichtung, die in ein Installationsverteilergehäuse einsetzbar und auf eine erste Leiterplatte kontaktierend aufsetzbar und in einem Gehäuse untergebracht ist, welches Gehäuse aus einem Gehäuseunterteil und einem daran anschnappbaren Gehäuseoberteil zusammengesetzt ist und eine zweite Leiterplatte sowie Schalt- und Steuerkomponenten enthält, gemäß dem Oberbegriff des Anspruches 1.

Angewendet werden solche Schalt- oder Steuereinrichtungen z. B. in EIB-Installationen, allgemeiner in einer sogenannten dezentralen Anschlusseinrichtung. Dabei ist in dem Gehäuse, das die Schalt- oder Steuereinrichtung aufnimmt, die nötige Elektronik für eine entsprechende Anwendung zur kundenspezifischen Komplettierung oder zur nachträglichen Erweiterung oder zu einer Anwendungsanpassung untergebracht. Die derzeit existierenden Einrichtungen sind auf einer Normprofiltragschiene, insbesondere einer Hutprofilschiene, montierbar.

Die EP 1 100 152 A3 zeigt einen Verteiler zum Verbinden von Aktoren und/oder Sensoren, bei dem eine zweite Leiterplatte in einem Gehäuse untergebracht ist, welches auf eine erste Leiterplatte in einem Verteilergehäuse kontaktierend aufsetzbar ist.

Aufgabe der Erfindung ist es, eine Schalt- oder Steuereinrichtung in einem Gehäuse unterzubringen, welches Gehäuse dicht abschlossen verschließt und ohne Werkzeug einfach zu montieren ist.

Diese Aufgabe wird erfindungsgemäß durch die Merkmale des Anspruches 1 gelöst.

Gemäß dem kennzeichnenden Teil ragt die zweite Leiterplatte aus einer Stirnseite aus dem Gehäuse heraus und ist mit einem Leiterplattenverbindungsstecker in elektrisch leitende Verbindung zu bringen; am Gehäuseunterteil an der einen Stirnseite ist ein parallel zur Leiterplatte vorspringender erster Haken angeformt, der hinter eine Aussparung am Installationsgehäuse greift; weiterhin ist ein zweiter Haken an der der einen Stirnseite des Gehäuses entgegengesetzt liegenden anderen Stirnseite angeformt, der in gleiche Richtung wie der erste Haken vorspringt und hinter eine durch eine Durchbrechung in der ersten Leiterplatte gebildete Kante greift.

Weitere vorteilhafte Ausgestaltungen der Erfindung sind den Unteransprüchen zu entnehmen.

Die Einrichtung besitzt ein Gehäuse, das nach IP 20 dicht verschließt und die folgenden Eigenschaften aufweist: das Ober- und Unterteil des Gehäuses sind ohne Einsatz von jeglichen Befestigungselementen wie z. B. Schrauben, Nieten etc. miteinander verbindbar. Die dazugehörige zweite Leiterplatte wird einfach in das Modulunterteil eingelegt und beim Aufschnappen des Gehäuseoberteils auf das Gehäuseunterteil wird die zweite Leiterplatte dann auch von oben durch entsprechende Stege im Oberteil fixiert.

Anhand der Zeichnung, in der ein Ausführungsbeispiel der Erfindung dargestellt ist, sowie weitere vorteilhafte Ausgestaltungen und Verbesserungen und weitere Vorteile näher erläutert und beschrieben werden.

Es zeigen:
- Fig. 1: einen Teilschnittansicht durch eine Einrichtung gemäß der Erfindung,
- Fig. 2: eine perspektivische Einsicht in das Gehäuseoberteil,
- Fig. 3: eine perspektivische Ansicht des Gehäuseunterteils von unten,
- Fig. 4: eine perspektivische Teilansicht des Gehäuses,
- Fig. 5: eine weitere perspektivische Teilansicht des Gehäuses,
- Fig. 6: die Montage zweier Gehäuse auf einer Leiterplatte, sowie
- Fig. 7 und 8: zwei unterschiedliche Ausgestaltungen zur Demontage des Gehäu^ ses.

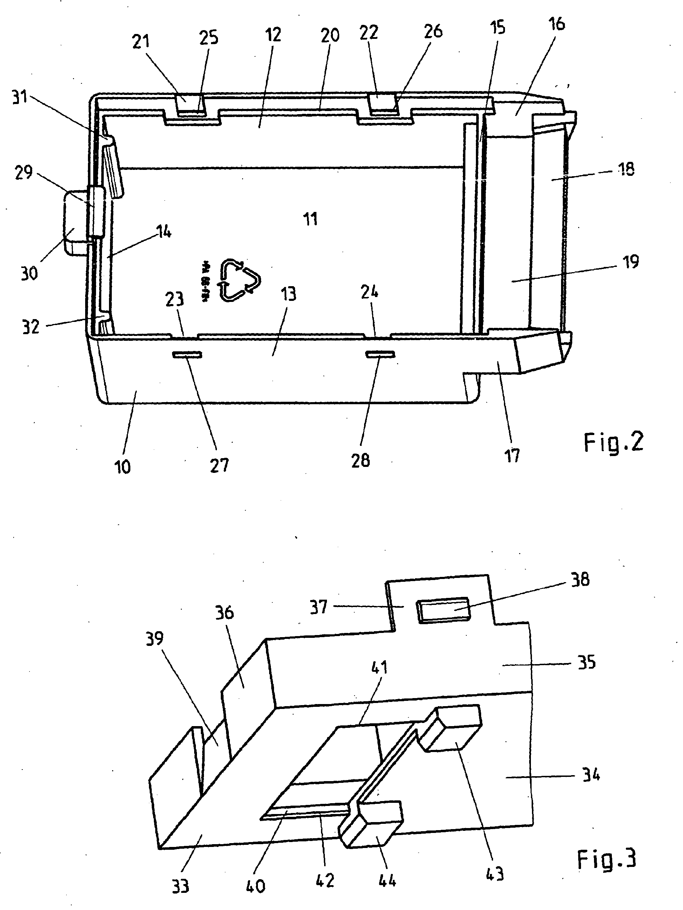

Es sei nun Bezug genommen auf die Fig. 2.

Diese Figur zeigt eine Einsicht in ein Gehäuseoberteil 10, mit einer im montierten Zustand oberen Wand 11 und drei Seitenwänden 12, 13 und 14; der Innenraum des Gehäuseoberteils 10 ist auf der der Wandung 14 entgegengesetzt liegenden Seite mit einer Wandung 15 abgeschlossen, an der in Verlängerung zu den Seitenwänden 12 und 13 Fortsätze 16 und 17 angeformt sind, deren freie Enden wiederum durch eine Querwandung 18 miteinander verbunden sind, so dass sich ein Aufnahmeraum 19 für eine Steckklemme (siehe weiter unten) gebildet ist. In Abstand zu den freien Randkanten der Wände 12, 13 und 14 ist eine umlaufende Stufe 20 vorgesehen, auf der eine Leiterplatte aufgelegt werden kann; die freie Kante der Wandung 15 liegt in der Ebene der Stufe 20. An den Seitenwänden 12 und 13 sind, von der Kante der Seitenwände 13 ausgehend, zur Wandung 11 hin verlaufende Vertiefungen 21, 22, 23 und 24 eingeformt, die in einer Durchbrechung 25, 26, 27 und 28 enden.

An der Seitenwand 14 ist ein Haken 29 und eine Ausformung 30 angeformt, siehe weiter unten. An der Innenfläche der Seitenwand 14 sind senkrecht zur freien Kante verlaufende, von der Stufe 20 ausgehende Leisten 31 und 32 angeformt, die zur Auflagerung der Leiterplatte beitragen.

Die Fig. 3 zeigt das zu dem Gehäuseoberteil gemäß Fig. 2 gehörige Gehäuseunterteil 33, welches eine Bodenwand 34 und senkrecht dazu vorstehende Seitenwandungen 35 und 36 aufweist; da die Fig. 3 lediglich eine Teilansicht des Gehäuseunterteils 33 darstellt, sind noch weitere, hier nicht sichtbare Seitenwandungen vorgesehen, die parallel zu den Seitenwandungen 35 bzw. 36 verlaufen.

An den Seitenwandungen 35 sind Laschen 37 vorgesehen, die senkrecht zur freien Kante der Wandungen 35 vorstehen und die an ihrer Außenfläche Vorsprünge bzw. Nasen 38 tragen, so dass dann, wenn das Gehäuseoberteil über das Gehäuseunterteil gesetzt wird, die Laschen 37 in den Vertiefungen 21 bis 24 gleiten und die Nasen 38 in die Durchbrüche 25, 26, 27 und 28 einrasten können.

Damit wird durch einfaches Übereinanderstecken des Gehäuseoberteils über das Gehäuseunterteil eine Verrastung über die Nasen 38 und die Durchbrüche 25 bis 28 erreicht.

Die Seitenwandung 36 besitzt, ausgehend von der Bodenwand 34, eine Abschrägung 39, über die beim Zusammenfügen der Haken 29 gleiten kann, so dass, wie weiter unten zu sehen ist, der Haken 29 über die Außenfläche der unteren Bodenwand 34 des Gehäuseunterteils 33 hervorragen kann.

Die Bodenwandung 34 besitzt eine rechteckige Öffnung 40, durch die Kontaktelemente (siehe unten) hindurchgreifen; weiterhin sind in Verlängerung der parallel zu den Seitenwandungen 35 verlaufenden Rändern 41 und 42 Führungsvorsprünge 43 und 44 vorgesehen, die von der Bodenseite bzw. der Außenfläche der Bodenwand 34 vorspringen.

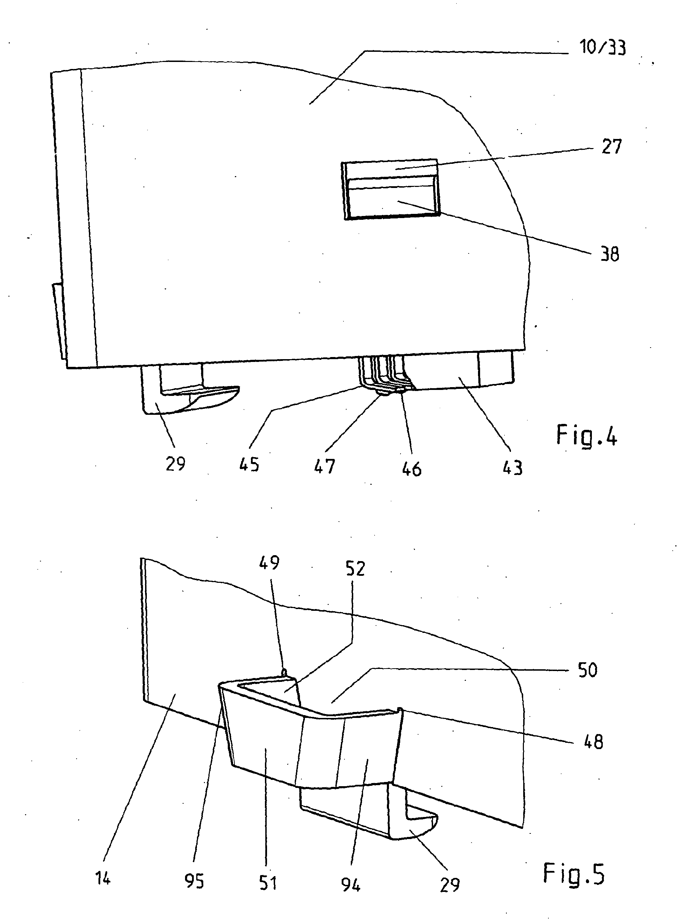

Die Fig. 4 zeigt eine Teilansicht auf das Gehäuse, welches hier mit 10/33 bezeichnet ist. Auf der Unterseite des Gehäuses 10/33 ragt der Haken 29 vor, der L-förmig ist und dessen freier Schenkel in Richtung zur Öffnung 40 gerichtet ist. Weiterhin sind in Fig. 4 L-förmige Kontaktarme 45 dargestellt, die durch die Öffnung 40 greifen und an deren parallel zur Bodenwandung verlaufenden Schenkeln 46 eine Kontaktnase oder Kontaktnoppe 47 angebracht ist, die mit entsprechenden Leiterbahnen auf einer Leiterplatte (siehe weiter unten) in Berührung gelangt, wenn das Gehäuse 10/33 montiert ist. Die Fig. 4 zeigt auch den Durchbruch 27 sowie die in dem Durchbruch sich befindende Nase 38.

Die Fig. 5 zeigt eine Aufsicht auf die Seitenwand 14 dem Haken 29, der an einem zwischen zwei Schlitzen 48 und 49 befindlichen federndem Arm 50 angeformt, welche von der freien Stirnkante der Wandung 14 V-förmig bis zu einer bestimmten Entfernung von der freien Kante der Wandung sich erstrecken, welcher Abstand geringer ist die halbe Höhe der Wandung 14. Am federnden Arm 50 ist ein rahmenartiger vorsprung 51 angebracht, der zusammen mit dem federnden Arm 50 eine Aufnahmeöffnung 52 bildet, in welche ein Werkzeug 53 eingreifen kann, welches dann, wenn es in Pfeilrichtung P, also im Uhrzeigersinn verschwenkt wird, sich gegen die Wandung 14 im Bereich der Wandung 11 anlegt und den Rahmen 51 zusammen mit dem federnden Arm 50 in Pfeilrichtung P1 auslenkt, wodurch der Haken 29 ebenfalls in Pfeilrichtung P1 bewegt wird.

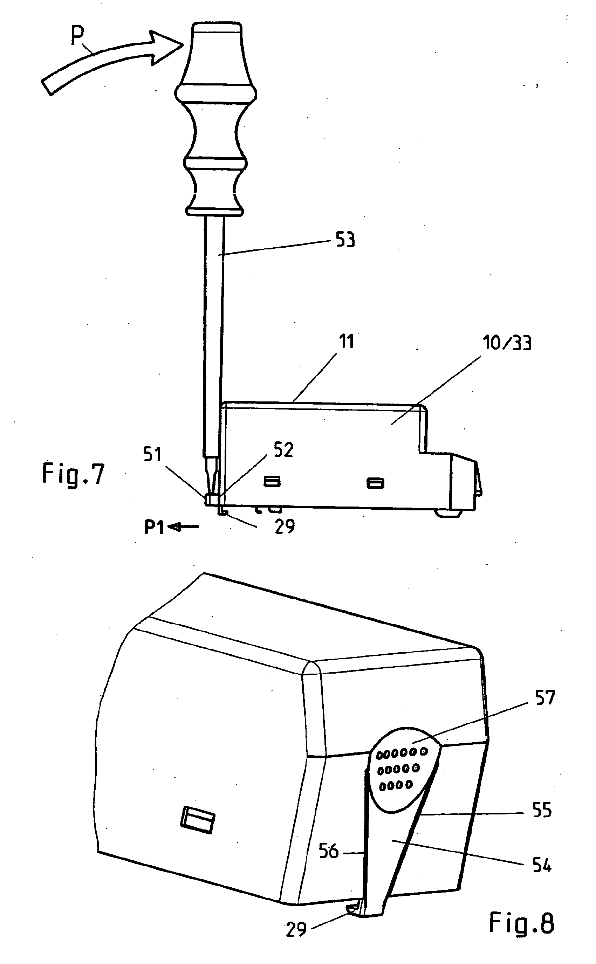

Der Haken 29 kann auch, wie in Fig. 8 dargestellt ist, an einem federnden Arm 54 angeformt sein, der durch zwei ebenfalls V-förmige Schlitze 55 und 56 gebildet ist; über eine Betätigungsmulde 57 kann der federnde Arm 54 verformt werden, so dass der Haken 29 sich in die gleiche Richtung bewegen kann wie der Haken 29 gemäß Fig. 7.

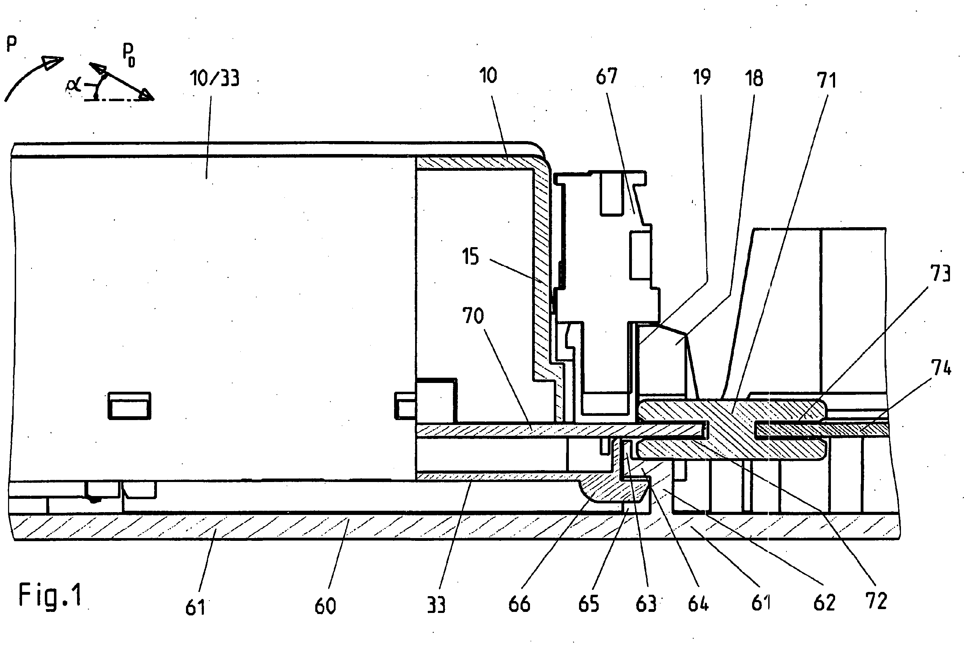

Zur Darstellung des Einbaus des Gehäuses 10/33 in ein Installationsverteilergehäuse 60 sein nun auf die Fig. 1 bezug genommen.

An der Innenfläche des Bodens 61 des Installationsverteilergehäuses ist eine Leiste 62 angeformt, die eine Z-Form aufweist, wobei der eine freie Schenkel der Z-Form am Boden 61 angeformt ist und senkrecht dazu verläuft; der zweite freie Schenkel 63 verläuft parallel zum ersten Schenkel 61 und der dazwischen befindliche Steg 64 verläuft parallel zur Bodenfläche des Bodens 61, wobei hierdurch eine Ausnehmung oder Hinterschneidung 65 oder Tasche 65 gebildet ist.

An der Bodenwand des Gehäuseunterteils ist ein weiterer Haken 66 angeformt, der im montierten Zustand in die Tasche 65 eingreift.

In das Gehäuseoberteil 10, und dort auf die Stufe 20, ist eine zweite Leiterplatte 70 eingelegt, die die Abschlusswand 18 überdeckt. In die Durchbrechung 19 ist eine Klemme 67 eingesteckt, über deren Aufbau hier nichts näheres gesagt werden soll, weil eine derartige Klemme zum Stand der Technik gehört. Der freie Steg 63 ragt vor bis zu der besagten Leiterplatte 70. Der freie Randbereich der zweiten Leiterplatte 70 ist überdeckt von einem Verbindungsstecker 71; dieser Verbindungsstecker 71 besitzt eine Aufnahmeöffnung 72, in die der freie Randbereich der zweiten Leiterplatte 70 eingreift. Die Verbindungsklemme hat eine weiter Ausnehmung 73, die in entgegengesetzte Richtung offen ist und in die eine weitere Leiterplatte 74 eingreift.

Wenn die Klemme 67 in die Aufnahmeöffnung 19 eingesteckt wird, dann legt sich die zweite Leiterplatte 70 auf den freien Rand des freien Schenkels 63, so dass sich die zweite Leiterplatte 70 nicht verbiegen kann und nicht beschädigt wird. Wenn die Klemme 67 herausgezogen wird, dann legt sich der Haken 66 an die der Tasche 65 zugewandte Fläche des Steges 64 an, so dass auch hier das Gehäuse nicht herausgezogen werden kann.

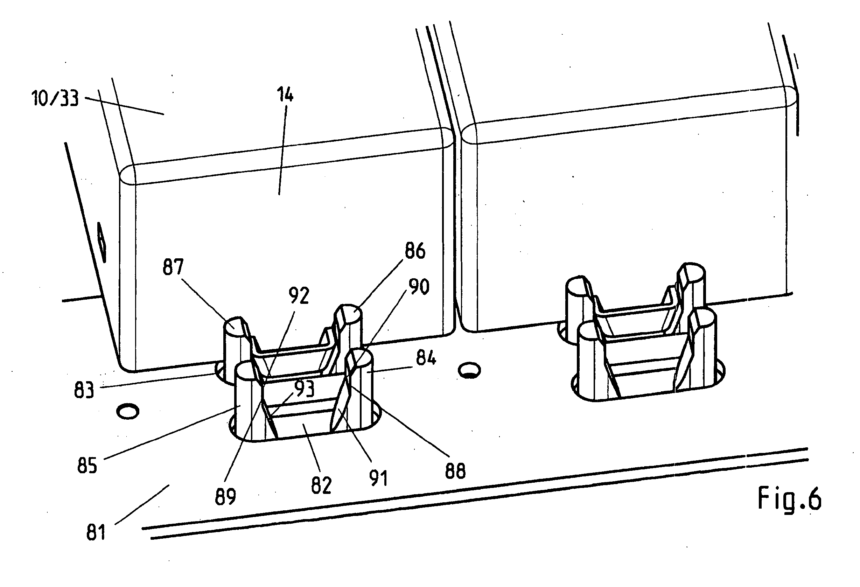

In das Installationsverteilergehäuse 60 ist eine erste Leiterplatte 81 eingelegt, wobei zur Führung der ersten Leiterplatte 81 Aussparungen 82 und 83 vorgesehen sind, in die am Boden des Installationsverteilergehäuses angeformte und senkrecht dazu vorstehende Zapfen 84 und 85 bzw. 86 und 87 eingreifen. Die sich gegenüberliegenden Flächenabschnitte 88 und 89 besitzen zwei Bereiche 90, 91 bzw. 92, 93, wobei die Abschnitte 90 und 92 parallel zueinander ausgerichtet sind. Die Durchbrechungen 82 und 83 sind als Langlöcher ausgebildet und das Gehäuse 10/33 ist diesen Langlöchern 83, 82 so zugeordnet, dass die hintere Wandung 14 parallel zur Längserstreckung der Ausnehmungen 82, 83 verläuft. Die Abschnitte 91 und 93 bilden miteinander eine V-Form, deren Öffnungswinkel zum Ende der Zapfen 84, 85 geöffnet ist und dem Winkel entspricht, den die beiden Schlitze 48 und 49 miteinander einschließen; die an diese Schlitze 48, 49 angrenzenden Wandungen 94 und 95 passen dann genau wie in der Fig. 6 ersichtlich ist, in die den Abschnitten 91 und 93 entsprechenden Abschnitte der Zapfen 86 und 87.

Zur Montage des Gehäuses 10/33 wird dieses schräg bei der Montageart gemäß Fig. 1 von links oben in den Verbindungsstecker 71 eingeführt, wobei gleichzeitig der Haken 66 in die Tasche 65 hineingleitet. Um den Einbau des Gehäuses 10/33 zu komplettieren, wird das Gehäuse 10/33 mit dem hinteren Teil, dort also wo der Haken 29 angeformt ist, in die Ausnehmung 83 eingefügt, wobei der Haken 29 beispielsweise mittels des Werkzeugs 53 oder bei der Ausführung gemäß Fig. 8 manuell verschwenkt wird; nach Einführen des Hakens 29 in die Ausnehmung 83 und Loslassen rastet der Haken 29 hinter die Leiterplatte 81 und die Tasche 51 wird durch die beiden Zapfen 86 und 87 mittels der den Abschnitten 91 und 93 der Zapfen 84 und 85 entsprechenden Abschnitte fixiert und zentriert. Dabei gelangen die Kontaktarme 45, 46 (siehe Fig. 4) mit auf der Leiterplatte 81 befindlichen Leiterbahnen in Berührung, so dass hierdurch eine Kontaktierung zwischen der Einrichtung und der Leiterplatte 81 erfolgt. Die beiden Vorsprünge 43 und 44 liegen an der unterhalb des Gehäuses 10/33 verlaufenden Kante der Leiterplatte 81 an, so dass ein Verschieben des Gehäuses 10/33 (in Fig. 1) nach links verhindert wird; in diesem Falle würden nämlich die Leiterplatte 70 aus dem Verbindungsstecker 21 und der Harken 66 aus der Tasche 65 herausgezogen.

Zur Demontage wird, wie in Fig. 7 oder 8 dargestellt, der Haken 29 in den Bereich der Aussparung 83 verschwenkt, so dass das Gehäuse 10/33 in Pfeilrichtung P (siehe Fig. 7) nach links oben verschwenkt werden und dann die Leiterplatte aus dem Verbindungsstecker 71 und der Haken 66 aus der Tasche 65 herausgezogen werden können. Das Abziehen, ebenso wie das Einfügen erfolgt gemäß der Doppelpfeilrichtung P_{D}, welche Richtung bezogen auf den Boden 61 einen Winkel α einnimmt, dessen Größe allerdings nicht definiert ist. Die Größe des Winkels α richtet sich insbesondere danach, welche Toleranzen im Verbindungsstecker 71 vorhanden sind.

## Patentansprüche

1. Schalt- oder Steuereinrichtung, die in ein Installationsverteilergehäuse einsetzbar und auf eine erste Leiterplatte kontaktierend aufsetzbar und in einem Gehäuse untergebracht ist, welches Gehäuse aus einem Gehäuseunterteil und einem daran anschnappbaren Gehäuseoberteil zusammengesetzt ist und eine zweite Leiterplatte sowie Schalt- und Steuerkomponenten enthält, **dadurch gekennzeichnet, dass** die zweite Leiterplatte (70) aus einer Stirnseite (15) aus dem Gehäuse (10/33) herausragt und mit einem Leiterplattenverbindungsstecker (71) in elektrisch leitende Verbindung bringbar ist, das an das Gehäuseunterteil an der Stirnseite, aus der die zweite Leiterplatte (70) herausragt, ein parallel zur zweiten Leiterplatte (70) vorspringender erster Haken (66) angeformt ist, der in eine Tasche (65) am Installationsgehäuse (60) greift, und dass ein zweiter Haken (29) an der der ersten Stirnseite des Gehäuses (10/33) entgegengesetzt liegenden zweiten Stirnseite angeordnet ist, der in die gleiche Richtung wie der erste Haken (66) vorspringt und hinter eine durch eine Ausnehmung (82, 83) in der ersten Leiterplatte (81) gebildete Kante greift.

2. Einrichtung nach Anspruch 1, **dadurch gekennzeichnet, dass** die Tasche (65) in einer senkrecht zum Boden (61) des Installationsverteilergehäuses (60) angeformten Leiste (61 bis 64) angeordnet ist.

3. Einrichtung nach Anspruch 2, **dadurch gekennzeichnet, dass** die Leiste (61 bis 64) L-förmig ausgebildet ist, wodurch die Tasche (65) gebildet ist.

4. Einrichtung nach Anspruch 3, **dadurch gekennzeichnet, dass** an dem freien Schenkel der L-Form ein senkrecht zum Boden verlaufender Vorsprung (63) angeformt ist, den die zweite Leiterplatte (70) überdeckt und der bis zur zweiten Leiterplatte (70) vorragt, wobei die Leiste dadurch eine Z-Form besitzt und der Haken 66 hinter den parallel zum Boden (61) verlaufenden Steg (64) greift.

5. Einrichtung nach einem der vorherigen Ansprüche, **dadurch gekennzeichnet, dass** aus der Unterseite des Gehäuses (10/33) Kontaktfedern (45) herausragen, die mit auf der ersten Leiterplatte (81) verlaufenden Leiterbahnen in elektrisch leitender Verbindung stehen.

6. Einrichtung nach einem der vorherigen Ansprüche, **dadurch gekennzeichnet, dass** der zweite Haken (29) an einem federnden Wandabschnitt (50, 54) an der parallel zur Stirnwand (15) verlaufenden Stirnwand (14) angeformt ist.

7. Einrichtung nach dem unmittelbar vorhergehenden Anspruch, **dadurch gekennzeichnet, dass** der Wandabschnitt (50, 54) durch Schlitze (48, 49; 55, 56) gebildet ist.

8. Einrichtung nach einem der vorherigen Ansprüche, **dadurch gekennzeichnet, dass** am federnden Wandabschnitt (50) ein Bügel (51), der eine Tasche (52) bildet, angeformt ist, so dass er durch Aushebelung mittels eines Werkzeugs verformbar ist (siehe Fig. 7).

9. Einrichtung nach einem der vorherigen Ansprüche, **dadurch gekennzeichnet, dass** der federnde Wandabschnitt (54) manuell verformbar ist.

10. Einrichtung nach einem der vorherigen Ansprüche, **dadurch gekennzeichnet, dass** am Boden (61) des Installationsverteilergehäuses (60) Zapfen vorgesehen sind, mittels denen die erste Leiterplatte (81) zentriert und zwischen denen die verformbare Tasche (52) zentriert ist.

## Claims

1. Switching or control device, which can be inserted into an installation distributor housing, can be placed on a first printed circuit board such that it makes contact and is accommodated in a housing, which housing comprises a housing lower part and a housing upper part which can be snapped thereon, and contains a second printed circuit board as well as switching and control components, **characterized in that** the second printed circuit board (70) projects from one end face (15) out of the housing (10/33) and can be electrically conductively connected to a printed circuit board connecting plug (71), **in that** a first hook (66) is integrally formed on the housing lower part, on the end face from which the second printed circuit board (70) projects, which first hook (66) projects parallel to the second printed circuit board (70) and engages in a pocket (65) on the installation housing (60), and **in that** a second hook (29) is arranged on the second end face, located opposite the first end face of the housing (10/33), projects in the same direction as the first hook (66), and engages behind an edge which is formed by a recess (82, 83) in the first printed circuit board (81).

2. Device according to Claim 1, **characterized in that** the pocket (65) is arranged in a strip (61 to 64) which is integrally formed at right angles to the base (61) of the installation distributor housing (60).

3. Device according to Claim 2, **characterized in that** the strip (61 to 64) is L-shaped, thus forming the pocket (65).

4. Device according to Claim 3, **characterized in that** a projection (63) which runs at right angles to the base is integrally formed on the free limb of the L-shape, covers the second printed circuit board (70) and projects as far as the second printed circuit board (70), with the strip thus being Z-shaped, and with the hook (66) engaging behind the web (64) which runs parallel to the base (61).

5. Device according to one of the preceding claims, **characterized in that** contact springs (45) project from the lower face of the housing (10/33) and are electrically conductively connected to conductor tracks which run on the first printed circuit board (81).

6. Device according to one of the preceding claims, **characterized in that** the second hook (29) is integrally formed on a sprung wall section (50, 54) on the end wall (14) which runs parallel to the end wall (15).

7. Device according to the immediately preceding claim, **characterized in that** the wall section (50, 54) is formed by slots (48, 49; 55, 56).

8. Device according to one of the preceding claims, **characterized in that** a bracket (51), which forms a pocket (52), is integrally formed on the sprung wall section (50) such that it can be deformed by levering up by means of a tool (see Figure 7).

9. Device according to one of the preceding claims, **characterized in that** the sprung wall section (54) can be deformed manually.

10. Device according to one of the preceding claims, **characterized in that** pins are provided on the base (61) of the installation distributor housing (60), by means of which pins the first printed circuit board (81) is centred, and between which the deformable pocket (52) is centred.

## Revendications

1. Dispositif de commande ou de commutation, qui peut être inséré dans un boîtier de distribution pour une installation, qui peut être posé sur une première carte de circuits imprimés en venant en contact avec elle et qui peut être monté dans un boîtier, lequel boîtier est constitué d'une partie inférieure de boîtier et d'une partie supérieure de boîtier pouvant s'encliqueter avec celle-ci, et contient une deuxième carte de circuits imprimés ainsi que des composants de commutation et de commande, **caractérisé en ce que** la deuxième carte de circuits imprimés (70) fait saillie hors d'un côté frontal (15) du boîtier (10/33) et peut être mise en contact électriquement conducteur avec un connecteur enfichable de connexion pour cartes de circuits imprimés (71), **en ce qu'**un premier crochet (66) saillant parallèlement à la deuxième carte de circuits imprimés (70) est façonné sur la partie inférieure de boîtier au niveau du côté frontal hors duquel fait saillie la deuxième carte de circuits imprimés (70), lequel premier crochet (66) vient en prise dans une poche (65) sur le boîtier pour installation (60), et **en ce qu'**un deuxième crochet (29) est disposé sur le deuxième côté frontal situé à l'opposé du premier côté frontal du boîtier (10/33), qui fait saillie dans la même direction que le premier crochet (66) et qui vient en prise derrière une arête formée par un évidement (82, 83) dans la première carte de circuits imprimés (81).

2. Dispositif selon la revendication 1, **caractérisé en ce que** la poche (65) est disposée dans une réglette (61 à 64) façonnée perpendiculairement au fond (61) du boîtier de distribution pour installation (60).

3. Dispositif selon la revendication 2, **caractérisé en ce que** la réglette (61 à 64) est réalisée en forme de L, de manière à former la poche (65).

4. Dispositif selon la revendication 3, **caractérisé en ce qu'**une saillie (63) s'étendant perpendiculairement au fond est façonnée sur la branche libre de la forme en L, est recouverte par la deuxième carte de circuits imprimés (70), et fait saillie jusqu'à la deuxième carte de circuits imprimés (70), la réglette possédant de ce fait une forme en Z et le crochet (66) venant en prise derrière la nervure (64) s'étendant parallèlement au fond (61).

5. Dispositif selon l'une quelconque des revendications précédentes, **caractérisé en ce que** des ressorts de contact (45) font saillie hors du côté inférieur du boîtier (10/33), lesquels sont en liaison électriquement conductrice avec des pistes conductrices s'étendant sur la première carte de circuits imprimés (81).

6. Dispositif selon l'une quelconque des revendications précédentes, **caractérisé en ce que** le deuxième crochet (29) est façonné sur une portion de paroi élastique (50, 54) sur la paroi frontale (14) s'étendant parallèlement à la paroi frontale (15).

7. Dispositif selon la revendication immédiatement précédente, **caractérisé en ce que** la portion de paroi (50, 54) est formée par des fentes (48, 49 ; 55, 56).

8. Dispositif selon l'une quelconque des revendications précédentes, **caractérisé en ce qu'**un étrier (51), qui forme une poche (52), est façonné sur la portion de paroi élastique (50), de sorte qu'il puisse être déformé par effet de levier appliqué par un outil (voir la figure 7).

9. Dispositif selon l'une quelconque des revendications précédentes, **caractérisé en ce que** la portion de paroi élastique (54) peut être déformée manuellement.

10. Dispositif selon l'une quelconque des revendications précédentes, **caractérisé en ce que** des tourillons sont prévus sur le fond (61) du boîtier de distribution pour installation (60), au moyen desquels la première carte de circuits imprimés (81) est centrée et entre lesquels la poche déformable (52) est centrée.
